# FASCICULE DE BREVET EUROPEEN

(11) **EP 0 751 701 B1**
(45) Date de publication et mention de la délivrance du brevet: **25.03.1998**
(21) Numéro de dépôt: 96401385.8
(22) Date de dépôt: 24.06.1996
(51) Int. Cl.: H05K 7/14

(54) **Bac pour modules électroniques**
Aufnahmerahmen für elektronische Module
Receptacle for electronic modules

(30) Priorité: 26.06.1995 FR 9507750
(43) Date de publication de la demande: 02.01.1997
(73) Titulaire: Schneider Automation, 06560 Valbonne (FR)
(72) Inventeur: Chabert, Jean-Marie, 06560 Valbonne (FR)
(74) Mandataire: Carias, Alain

(56) Documents cités:
- DE-U- 8 411 255
- GB-A- 805 175

## Description

La présente invention concerne un bac de type modulaire, pour un appareil comprenant un certain nombre de modules électroniques, par exemple un automate programmable.

Les bacs modulaires destinés à loger des modules électroniques comprennent habituellement un châssis dont le volume interne est partagé en compartiments modulaires définissant des ouvertures antérieures, les compartiments pouvant loger chacun au moins un boîtier d'un module électronique fonctionnel.

Selon la configuration propre à l'application du bac, les compartiments sont totalement ou partiellement occupés par des modules électroniques ; il est souhaitable que les ouvertures frontales des compartiments non occupés soient masquées par des éléments peu coûteux et faciles à monter. Il est aussi souhaitable de pouvoir démonter facilement ces éléments pour installer dans le bac des modules électroniques supplémentaires complétant la configuration initiale de l'appareil.

Lorsque les compartiments modulaires du châssis sont séparés les uns des autres par des cloisons verticales, le châssis étant par exemple réalisé par moulage, il est d'autre part nécessaire que le châssis possède une bonne rigidité mécanique.

L'invention a pour but de permettre de masquer de manière simple les ouvertures des compartiments - ou de leurs parties inoccupées - d'un bac du type décrit, tout en contribuant à la bonne rigidité de ce bac.

Selon l'invention, chaque partie de compartiment modulaire non équipée d'un module fonctionnel loge un module factice dont le boîtier comporte une paroi avant verticale occultant la partie correspondante de l'ouverture du compartiment et une paroi latérale verticale adjacente à une cloison verticale.

De préférence, les cloisons verticales présentent des éléments fixes de blocage, par exemple des cames fixes, agencés pour coopérer alternativement avec des organes déplaçables de blocage prévus sur les modules fonctionnels et sur les modules factices.

Les organes déplaçables en question peuvent être des leviers pivotants s'accrochant derrière les cames fixes de blocage ; pour simplifier la réalisation du module factice, il peut s'agir dans ce cas d'une languette élastique d'encliquetage déblocable par un outil passant dans un orifice de la paroi avant du module factice.

La description qui suit d'un mode de réalisation non limitatif est faite en regard des dessins pour expliciter les points caractéristiques et les avantages de l'invention.
- la figure 1 représente en perspective éclatée un châssis d'automate programmable conforme à l'invention.
- la figure 2 en est une vue de face schématique.
- la figure 3 montre en perspective un module factice.
- la figure 4 est une élévation du module factice partiellement engagé dans le compartiment correspondant.
- la figure 5 est une coupe d'un détail du module factice selon le plan A-A de la figure 4.

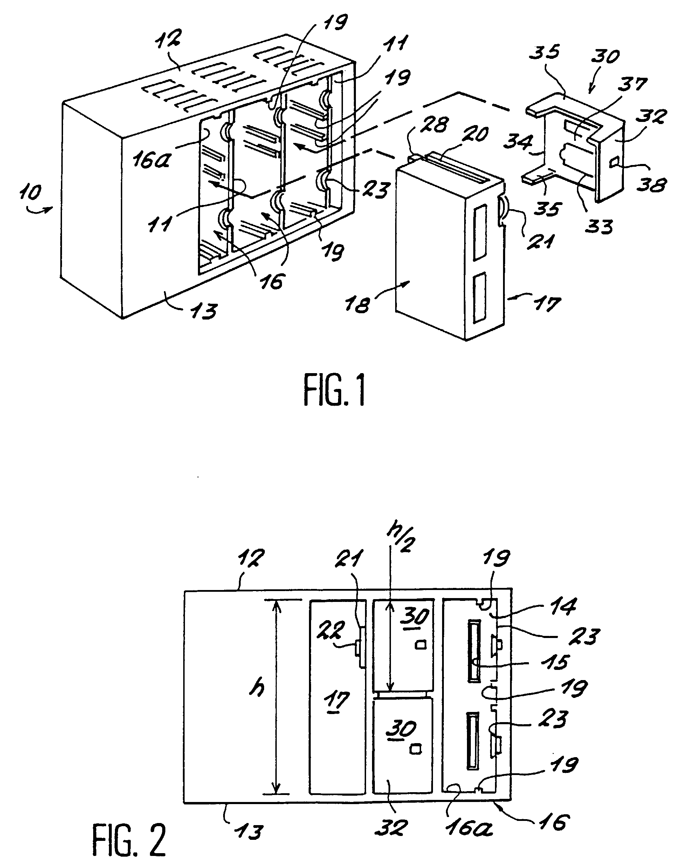

L'automate programmable illustré sur les figures 1 et 2 comprend un châssis 10 moulé en matière isolante et doté de cloisons latérales verticales 11, d'une paroi supérieure horizontale 12 et d'une paroi inférieure horizontale 13 munies de fentes de convection, ainsi que d'une paroi verticale arrière 14 dotée d'évidements, 15 pour le passage de connecteurs arrière des modules.

Le châssis 10 définit ainsi un volume interne partagé par les cloisons verticales 11 en compartiments modulaires 16 dont chacun est destiné à loger, soit un module fonctionnel d'interface actif 17 de hauteur h, soit deux tels modules fonctionnels de hauteur h/2. C'est ce dernier cas qui sera décrit par la suite.

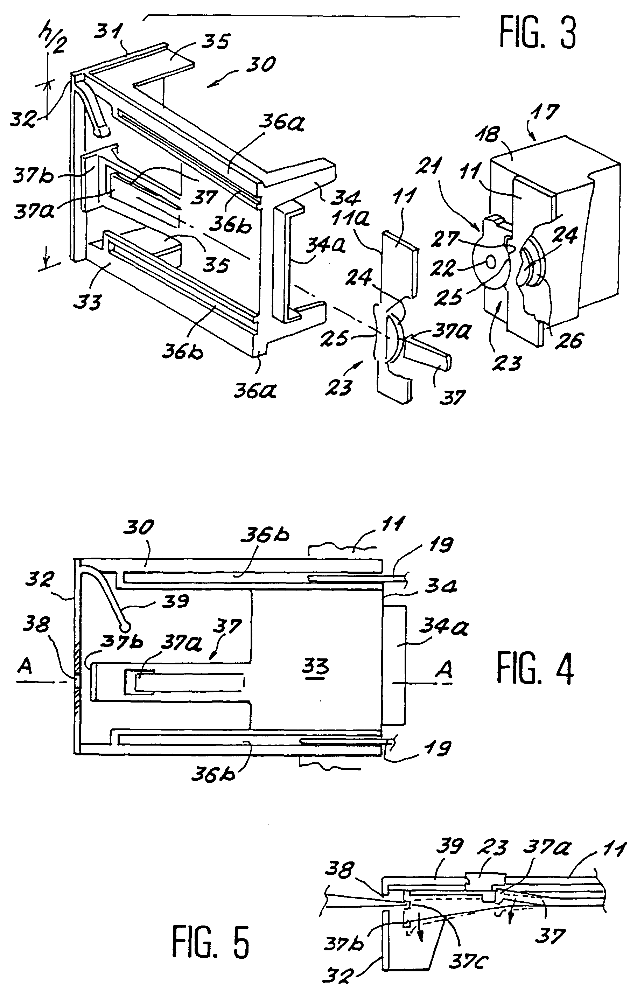

Les modules d'interface 17 comprenant des boîtiers parallélépipédiques 18 introduits dans le châssis 10 au moyen d'une part de glissières 19 prévues dans les compartiments à l'intérieur des parois 12, 13 et sur un côté des cloisons 11 et d'autre part d'éléments coopérants tels que des rainures 20 prévues sur les faces correspondantes des boîtiers. Sur le côté du boîtier 18 et vers l'avant de celui-ci est prévu un moyen de fixation tel qu'un levier de verrouillage 21 de forme plate, apte à pivoter sur un tourillon 22 d'axe horizontal et à coopérer avec un élément fixe de blocage tel qu'une came 23 située à l'avant et sur le côté de la cloison 11. Comme on le voit sur la figure 3, le levier 21 coopère avec les faces convexe 24 et respectivement concave 25 de la came au moyen d'un bras incurvé d'accrochage 26 et d'une forme centrale 27 qui est convenablement profilée et se développe autour du tourillon 22. Pour mieux comprendre la constitution et le fonctionnement de ce dispositif, on se reportera à la demande de brevet FR-94 05713 du 06.05.94. A l'avant du boîtier du module d'interface 17 peut se monter et se connecter un bornier non représenté de liaison avec les organes d'entrée ou de sortie gérés par l'automate ; à l'arrière du boîtier 17 est prévu un connecteur 28 de liaison avec l'unité centrale de l'automate.

Le module factice 30 comporte un boîtier 31 de hauteur h/2 qui présente une paroi avant verticale 32, une paroi latérale verticale 33 et une paroi arrière verticale échancrée 34, ainsi que des voiles horizontaux supérieur et inférieur 35 qui assurent une bonne rigidité du boîtier, tout en offrant des évidements qui permettent une bonne convection de l'air qui passe par les fentes des parois 12, 13.

Le module factice peut être introduit dans un demi-compartiment du châssis libre de module fonctionnel par coulissement de nervures haute et basse 36a bordant les parties haute et basse de la paroi latérale 33 et de rainures latérales 36b de cette même paroi dans les glissières 19 du châssis. Lorsque le module factice est monté, sa paroi avant 32 occulte l'ouverture antérieure 16a du compartiment 16. La paroi amère 34 du module factice présente une partie en saillie 34a qui s'emboîte dans un évidement 15 de la paroi arrière du châssis de l'automate. La figure 1 montre en vue éclatée un grand module fonctionnel 17 destiné à venir dans le compartiment 16 le plus à gauche du châssis et un module factice 30 de demi-hauteur destiné à se loger dans un demi-compartiment central 16. La figure 2 montre deux modules factices 30 logés dans ce même compartiment central, tandis que le compartiment 16 le plus à droite est représenté libre de tout module.

Dans sa position de montage, le module factice 30 est bloqué par un organe de verrouillage constitué par une languette d'encliquetage élastique 37 ménagée en tant que partie souple de la paroi latérale 33, cette paroi étant par ailleurs rigide. La languette 37 présente un bec 37a qui coopère avec la face arrière convexe 24 de la came prévue à l'avant de la cloison 11. La languette se termine vers l'avant par un talon transversal 37b muni d'une encoche 37c. On a représenté au centre de la figure 3 par une vue arrachée le bec 37a de la languette élastique du boîtier factice en butée sur la face arrière 24 de la came 23 associée à la cloison 11 et à droite de la figure 3 le levier 21 d'un module fonctionnel voisin 17 en prise sur la came 23 de la cloison 11 voisine. La paroi avant 32 du module factice 30 présente une ouverture 38 qui permet l'introduction d'un outil dont la pointe s'engage ainsi (voir figure 5) dans l'encoche 37c pour déplacer la languette vers une position, indiquée en tirets, dans laquelle le bec se dégage de sa position de butée contre la came 23, ce qui libère le boîtier 31.

Le boîtier 31 est en matière plastique et il est obtenu par moulage ; un doigt élastique 39 venu de moulage est prévu latéralement à la paroi 33 pour prendre appui sur la tranche 11a de la cloison 11 lorsque le boîtier termine sa course d'introduction dans le compartiment. Le doigt élastique est contraint dans la position de montage, ce qui facilite l'extraction dès que le bec 37a a été libéré de la came 23

Dans un mode de réalisation plus onéreux, on peut prévoir sur le boîtier du module factice un levier de verrouillage semblable à celui du module électronique fonctionnel.

## Revendications

1. Bac de type modulaire pour appareil électronique, notamment pour automate programmable, comprenant:
- un châssis dont le volume interne est partagé en compartiments modulaires séparés par des cloisons verticales et définissant des ouvertures antérieures,
- les compartiments pouvant loger chacun en totalité ou en partie un module électronique fonctionnel présentant un boîtier qui est équipé de moyens de fixation au châssis,
caractérisé par le fait que :
- chaque partie de compartiment modulaire (16) non équipée d'un module fonctionnel (17) loge un module factice (30),
- le boîtier (31) du module factice comporte une paroi avant verticale (32) occultant la partie correspondante de l'ouverture (16a) du compartiment et une paroi latérale verticale (33) adjacente à une cloison verticale (11) du châssis.

2. Bac selon la revendication 1, caractérisé par le fait que les cloisons verticales (11) présentent des éléments fixes de blocage (23) agencés pour coopérer d'une part avec un organe déplaçable de blocage (21) du module fonctionnel et d'autre part avec un organe déplaçable de blocage (37) du module factice.

3. Bac selon la revendication 2, caractérisé par le fait que le boîtier (31) du module factice (30) comporte, en saillie par rapport à sa paroi latérale (33), un organe élastique de blocage tel qu'une languette d'encliquetage (37) pour coopérer avec une butée de blocage (24) qui fait partie de l'élément fixe de blocage (23) prévu sur la paroi pour coopérer avec l'organe de blocage du module fonctionnel.

4. Bac selon l'une des revendications 1 à 3, caractérisé par le fait que le boîtier (31) du module factice (30) comprend une nervure de guidage (36a) disposée sensiblement dans le prolongement de sa paroi latérale verticale (33).

5. Bac selon l'une des revendications 2 à 4, caractérisé par le fait que l'organe de blocage (37) du module factice (30) est accessible à un outil de déblocage au travers d'un orifice (38) ménagé dans la paroi avant (32) du module factice.

6. Bac selon l'une des revendications 3 à 5, caractérisé par le fait que le boîtier (31) du module factice (30) est moulé, l'organe élastique d'encliquetage (37) venant de moulage avec sa paroi latérale (33), un doigt élastique (39) venu de moulage étant prévu sur un côté extérieur de la paroi latérale pour prendre appui contre la tranche (11a) de la cloison verticale (11).

## Patentansprüche

1. Kasten eines modularen Typs für Elektronikgeräte, insbesondere für programmierbare Steuerungen, mit:
- einem Rahmen, dessen Innenvolumen in modulare, von senkrechten und vordere Öffnungen definierenden Wänden getrennte Abteile unterteilt ist,
- Abteilen, die jeweils ein ganzes oder teilweises funktionelles Elektronikmodul aufnehmen können, das ein mit Befestigungsmitteln am Rahmen ausgerüstetes Gehäuse aufweist,
dadurch gekennzeichnet, dass:
- jeder Teil des modularen Abteils (16), der nicht mit einem funktionellen Modul (17) ausgerüstet ist, ein künstliches Modul (30) aufnimmt,
- das Gehäuse (31) des künstlichen Moduls eine senkrechte Vorderwand (32) aufweist, die den entsprechenden Teil der Öffnung (16a) des Abteils abdeckt, und eine senkrechte Seitenwand (33), die an eine senkrechte Wand (11) des Rahmens angrenzt.

2. Kasten nach Anspruch 1, dadurch gekennzeichnet, dass die senkrechten Wände (11) feste Blockierelemente (23) aufweisen, die so angeordnet sind, dass sie einerseits mit einem verschiebbaren Blockierorgan (21) des funktionellen Moduls und andererseits mit einem verschiebbaren Blockierorgan (37) des künstlichen Moduls zusammenwirken.

3. Kasten nach Anspruch 2, dadurch gekennzeichnet, dass das Gehäuse (31) des künstlichen Moduls (30) ein in bezug auf seine Seitenwand (33) herausragendes, elastisches Blockierelement umfasst, beispielsweise eine Einklinklasche (37), um mit einem Blockieranschlag (24) zusammenzuwirken, der zum an der Wand vorgesehenen festen Blockierelement (23) gehört, um mit dem Blockierorgan des funktionellen Moduls zusammenzuwirken.

4. Kasten nach einem der Ansprüche 1 bis 3, dadurch gekennzeichnet, dass das Gehäuse (31) des künstlichen Moduls (30) eine Führungsrippe (36a) aufweist, die etwa in der Verlängerung seiner senkrechten Seitenwand (33) angeordnet ist.

5. Kasten nach einem der Ansprüche 2 bis 4, dadurch gekennzeichnet, dass das Blockierorgan (37) des künstlichen Moduls (30) einem Freisetzungswerkzeug zugänglich ist, das durch eine in der Vorderwand (32) des künstlichen Moduls vorgesehene Öffnung (38) eingeführt wird.

6. Kasten nach einem der Ansprüche 3 bis 5, dadurch gekennzeichnet, dass das Gehäuse (31) des künstlichen Moduls (30) geformt ist, wobei das elastische Einklinkorgan (37) mit seiner Seitenwand (33) angeformt ist, und ein angeformter elastischer Finger (39) an einer Aussenseite der Seitenwand vorgesehen ist, um sich gegen den Rand (11a) der senkrechten Wand (11) abzustützen.

## Claims

1. Modular type subrack for electronic equipment, for example for programmable automatic controllers, comprising:
- a chassis the internal volume of which is divided into modular compartments separated by vertical partitions and having open fronts,
- the compartments being each adapted to house in total or in part a functional electronic module housed in a box which is provided with means for fixing it to the chassis,
characterised in that:
- each part of the modular compartment (16) not fitted with a functional module (17) houses a dummy module (30),
- the box (31) of the dummy module has a vertical front wall (32) blanking off the corresponding part of the open side (16a) of the compartment and a vertical lateral wall (33) adjacent a vertical partition (11) of the chassis.

2. Subrack according to claim 1 characterised in that the vertical partitions (11) have fixed locking members (23) adapted to cooperate with a movable locking member (21) of the functional module and with a movable locking member (37) of the dummy module.

3. Subrack according to claim 2 characterised in that the box (31) of the dummy module (30) has a resilient locking member such as a snap-fastener tang (37) projecting from its lateral wall (33) to cooperate with a locking abutment (24) that is part of the fixed locking member (23) provided on the wall to cooperate with a locking member of the functional module.

4. Subrack according to any one of claims 1 to 3 characterised in that the box (31) of the dummy module (30) includes a guide rib (36a) substantially in line with its vertical lateral wall (33).

5. Subrack according to any one of claims 2 to 4 characterised in that the locking member (37) of the dummy module (30) is accessible to an unlocking tool through an orifice (38) in the front wall (32) of the dummy module.

6. Subrack according to any one of claims 3 to 5 characterised in that the box (31) of the dummy module (30) is moulded, the resilient snap-fastener member (37) being moulded in one piece with its lateral wall (33), a resilient finger (39) moulded in one piece with it being provided on an exterior side of the lateral wall to bear against the edge (11a) of the vertical partition (11).
